Europäisches Patentamt

European Patent Office

Office européen des brevets

(11) Numéro de publication: **0 252 852 B1**

## FASCICULE DE BREVET EUROPEEN

(45) Date de publication de fascicule du brevet: **29.04.92**

(51) Int. Cl.⁵: **G06F 3/05**, D06F 39/00

(21) Numéro de dépôt: **87401636.3**

(22) Date de dépôt: **10.07.87**

(54) **Dispositif d'introduction de données dans un microprocesseur, notamment pour la commande d'un lave-linge.**

(30) Priorité: **10.07.86 FR 8610069**

(43) Date de publication de la demande:
**13.01.88 Bulletin 88/02**

(45) Mention de la délivrance du brevet:
**29.04.92 Bulletin 92/18**

(84) Etats contractants désignés:
**AT BE CH DE ES FR GB GR IT LI LU NL SE**

(56) Documents cités:
**DE-A- 3 203 485**
**GB-A- 2 016 841**
**GB-A- 2 020 934**
**GB-A- 2 054 301**

(73) Titulaire: **CIAPEM**
**137, rue de Gerland**
**F-69007 - Lyon(FR)**

(72) Inventeur: **Delhomme, Bernard**
**Thomson CSF SCPI-19, avenue de Messine**
**F-75008 Paris(FR)**
Inventeur: **Garofalo, François**
**Thomson CSF SCPI-19, avenue de Messine**
**F-75008 Paris(FR)**
Inventeur: **Gonon, Martine**
**Thomson CSF SCPI-19, avenue de Messine**
**F-75008 Paris(FR)**

(74) Mandataire: **Grynwald, Albert et al**
**THOMSON-CSF SCPI**
**F-92045 PARIS LA DEFENSE CEDEX 67(FR)**

Rank Xerox (UK) Business Services
(−/2.18/2.0)

## Description

L'invention est relative à un dispositif d'introduction de données dans un microprocesseur, notamment pour la commande d'un appareil électroménager tel qu'un lave-linge.

L'introduction de données analogiques dans un microprocesseur est habituellement effectuée à l'aide d'un convertisseur analogique/numérique d'un prix relativement élevé.

L'invention permet de se passer d'un tel convertisseur.

Par ailleurs il est connu (GB-A-2 016 841) un dispositif à condensateur pour l'introduction, dans un appareil, de données analogiques représentées par la position du curseur d'un potentiomètre, ce dispositif permettant de déterminer le temps de charge ou décharge du condensateur en fonction de la valeur de la résistance totale du potentiomètre et le temps de charge ou décharge de ce condensateur en fonction de la valeur de la résistance présentée par ce potentiomètre entre une borne d'extrémité et le curseur. Mais ce dispositif connu, qui fait appel à une source de courant constant et à un comparateur, est de réalisation complexe.

L'invention utilise également la charge et la décharge d'un condensateur afin de déterminer la position du curseur d'un potentiomètre, mais elle est de réalisation beaucoup plus simple.

L'invention concerne donc un dispositif à condensateur pour l'introduction, dans un appareil, de données analogiques représentées par la position du curseur d'un potentiomètre qui permet de déterminer le temps de charge ou décharge du condensateur en fonction de la valeur de la résistance totale du potentiomètre et le temps de charge ou décharge de ce condensateur en fonction de la valeur de la résistance présentée par ce potentiomètre entre une borne d'extrémité et le curseur, qui est caractérisé en ce que ledit appareil étant un microprocesseur (10) les temps $t_2$ et $t'_2$ sont les temps de charge ou décharge de ce condensateur (16) à travers, respectivement la résistance totale du potentiomètre et la résistance présentée par ce potentiomètre entre ladite borne d'extrémité ($19_1$) et le curseur ($19_3$), et en ce que la position ($\alpha$) du curseur est déterminée par la formule :

$$\alpha = \frac{t'_2}{t_2}$$

On introduit ainsi avec précision dans le microprocesseur la donnée constituée par la position du curseur d'un potentiomètre bien que la valeur de la résistance totale du potentiomètre ne soit pas connue avec une grande précision.

Le dispositif selon l'invention s'applique aux appareils électroménagers, notamment aux programmateurs de commande de lave-linge. Le potentiomètre sert, par exemple, à afficher une valeur désirée de vitesse de rotation du tambour pour l'essorage ou une charge de linge, le microprocesseur déterminant les divers paramètres de fonctionnement du lave-linge en fonction de cette charge.

D'autres caractéristiques et avantages de l'invention apparaîtront avec la description de certains de ses modes de réalisation, celle-ci étant effectuée en se référant aux dessins ci-annexés sur lesquels :

- la figure 1 est un schéma d'un microprocesseur et d'un dispositif d'introduction de données selon l'invention et,
- la figure 2 est un diagramme se rapportant au fonctionnement du dispositif de la figure 1.

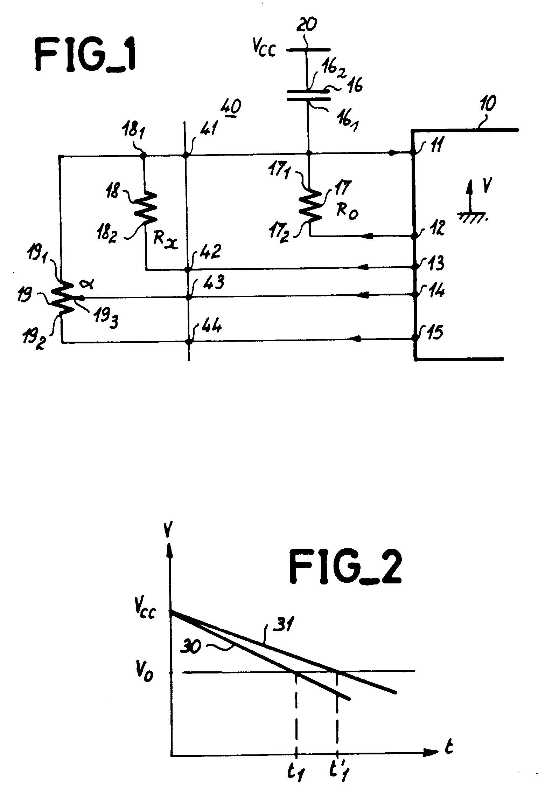

Le microprocesseur 10 (figure 1) présente une entrée 11 et quatre sorties de commande 12, 13, 14 et 15.

A l'entrée 11 sont reliées : une armature $16_1$ d'un condensateur 16, une première borne $17_1$ d'une résistance 17 de valeur $R_0$ de référence, une borne $18_1$ d'une résistance 18 de valeur $R_x$ à mesurer, et une première borne d'extrémité $19_1$ d'un potentiomètre 19 de résistance totale P, dont on veut déterminer la position du curseur.

La seconde armature $16_2$ du condensateur 16, de capacité C, est reliée à une borne 20 sur laquelle est appliqué un potentiel continu $V_{cc}$ de référence.

La seconde borne $17_2$ de la résistance de référence 17 est reliée à la sortie 12.

La seconde borne $18_2$ de la résistance 18 est connectée à la sortie 13.

La seconde borne d'extrémité $19_2$ du potentiomètre 19 est relié à la sortie 15 tandis que la prise, ou curseur, $19_3$ de ce potentiomètre est connectée à la sortie 14 du microprocesseur 10.

Pour effectuer la mesure de la valeur $R_x$ de la résistance 18 la borne 11 est portée au potentiel $V_{cc}$, ce qui permet de décharge le condensateur 16. Ensuite le potentiel $V_{cc}$ est supprimé de la borne 11, qui redevient ainsi une entrée. Puis la sortie 12 est portée au potentiel de 0 volt (celui de la masse), tandis que les sorties 13, 14 et 15 restent "en l'air". Dans ces conditions le condensateur 16 se charge à travers la résistance 17. A l'instant t = 0, correspondant au début de la connexion de la sortie 12 à la masse, le potentiel à l'entrée 11 est $V_{cc}$ (celui de la borne 20) ; ensuite ce potentiel à l'entrée 11, qui est représenté par la courbe 30 sur la figure 2, diminue pour atteindre une valeur $V_0$, qui consitue le seuil de mesure de l'entrée du microprocesseur, au bout d'un temps $t_1$. Le microprocesseur transforme ce temps $t_1$ en un nombre qui est conservé en mémoire.

Ensuite on décharge de nouveau le condensateur 16 en reliant temporairement la borne 11 au potentiel $V_{cc}$ ; puis on charge ce condensateur 16 à travers la résistance 18 en connectant la sortie 13 à la masse et en laissant les sorties 12, 14 et 15 en l'air. Le potentiel sur la borne 11 est alors représenté par la courbe 31 sur la figure 2; il atteint la valeur $V_0$ au temps $t'_1$.

Le temps $t_1$ obéit à la relation suivante :

$$t_1 = R_0.C.K.$$

Dans cette formule K est une constante qui dépend de $V_0$ et du microprocesseur.

De même le temps $t'_1$ satisfait à la relation :

$$t'_1 = R_x.C.K.$$

Dans ces conditions on peut écrire :

$$R_x = R_0 \frac{t'_1}{t_1}$$

Ainsi la précision sur la valeur $R_x$ de la résistance 18 dépend de la précision sur $R_0$, qui est par exemple de ± 1 %, et de la précision, qui peut être grande, sur les valeurs $t'_1$ et $t_1$.

Par contre la valeur mesurée est indépendante de $V_0$ (seuil d'entrée du microprocesseur) et de C.

La résistance 18 est, dans une réalisation, une thermistance de mesure de la température de l'eau se trouvant dans la cuve d'un lave-linge.

Pour déterminer la position du curseur $19_3$ du potentiomètre 19 on procède d'une manière analogue à celle qui a été décrite précédemment, à savoir qu'on décharge d'abord le condensateur 16, puis on charge ce condensateur 16 à travers la résistance totale du potentiomètre 19 en raccordant la borne 15 à la masse, les autres bornes 12 à 14 étant en l'air et on détermine le temps $t_2$ au bout duquel le potentiel de la borne 11 atteint la valeur $V_0$. Ensuite, après avoir déchargé de nouveau le condensateur 16, la borne 14 est mise à la masse et les bornes 12, 13 et 15 sont en l'air et on détermine le temps $t'_2$ au bout duquel le potentiel de la borne 11 atteint la valeur $V_0$. La valeur de la résistance entre les bornes $19_1$ et $19_3$ est $\alpha$ P.

Dans ces conditions on peut écrire :

$$\alpha \frac{P}{P} = \frac{t'_2}{t_2}$$

soit :

$$\alpha = \frac{t'_2}{t_2}$$

La position du curseur $19_3$ est représentée par le nombre $\alpha$ qui est indépendant de la valeur P de la résistance totale du potentiomètre 19. On peut ainsi afficher avec précision une grandeur bien que la valeur de la résistance totale du potentiomètre ne soit connue qu'avec une faible précision.

Le potentiomètre 19 peut être utilisé dans un lave-linge pour l'affichage de la température désirée de l'eau de lavage, pour afficher la vitesse de rotation désirée pour le tambour lors de l'essorage ou encore pour afficher la charge de linge introduite dans le tambour, le microprocesseur 10 déterminant alors les divers paramètres du lavage en fonction de cette charge ainsi affichée.

Le microprocesseur 10, le condensateur 16, la résistance 17 ainsi que la source d'alimentation de la borne 20 sont habituellement disposés sur une même plaquette 40 de circuit imprimé qui présente alors quatre entrées 41, 42, 43 et 44 reliées respectivement aux bornes 11, 13, 14 et 15. Ainsi la résistance 19 sera connectée entre les bornes 41 et 44 tandis que sa prise $19_3$ est reliée à la borne 43.

## Revendications

1. Dispositif à condensateur (16) pour l'introduction, dans un appareil, de données analogiques représentées par la position du curseur ($19_3$) d'un potentiomètre (19), ce dispositif déterminant le temps ($t_2$) de charge ou décharge du condensateur (16) en fonction de la résistance totale ($19_1$, $19_2$) du potentiomètre et le temps ($t'_2$) de charge ou décharge du condensateur (16) en fonction de la résistance présentée par le potentiomètre (19) entre une borne d'extrémité ($19_1$) et le curseur ($19_3$), caractérisé en ce que ledit appareil étant un microprocesseur (10), les temps $t_2$ et $t'_2$ sont les temps de charge ou décharge du condensateur (16) à travers, respectivement, la résistance totale du potentiomètre et la résistance présentée par ce potentiomètre entre ladite borne d'extrémité ($19_1$) et le curseur ($19_3$), et en ce que la position ($\alpha$) du curseur est déterminée par la formule :

$$\alpha = \frac{t'_2}{t_2}$$

2. Dispositif selon la revendication 1, caractérisé en ce que le condensateur (16) et le potentiomètre (19) présentent une borne ($18_1$, 41) reliée à une entrée (11) du microprocesseur, lesdits temps ($t_2$, $t'_2$) étant ceux mis par le potentiel sur cette entrée (11) pour atteindre une valeur prédéterminée (VO).

3. Dispositif selon la revendication 1 ou 2, caractérisé en ce qu avant la mesure le condensateur (16) est déchargé.

4. Dispositif selon la revendication 2, caractérisé en ce que le curseur ($19_3$) du potentiomètre est connecté à une borne (14) qui est portée à un potentiel déterminé, par exemple celui de la masse, lors de la mesure du temps de charge ou décharge à travers la résistance.

5. Dispositif selon la revendication 2 ou 4, caractérisé en ce que l'extrémité ($19_2$) du potentiomètre qui est opposée à l'entrée (11) du microprocesseur est connectée à une borne (15) qui est portée à un potentiel déterminé, par exemple celui de la masse, lors de la mesure du temps de charge ou décharge à travers la résistance.

6. Dispositif selon la revendication 4 ou 5, caractérisé en ce que la borne (14, 15) portée à un potentiel déterminé est une sortie du microprocesseur.

7. Dispositif selon la revendication 2, 4, 5 ou 6, caractérisé en ce que la valeur prédéterminée ($V_0$) constitue un seuil d'entrée (11) du microprocesseur.

8. Application du dispositif selon l'une quelconque des revendications 1 à 7 à l'affichage d'une valeur de consigne pour la commande d'un lave-linge telle que la température désirée pour l'eau de lavage, la vitesse désirée pour la rotation du tambour lors de l'essorage, ou la charge du linge introduite dans le tambour.

**Claims**

1. A capacitor device (16) serving to feed an apparatus with analog data represented by the position of the wiper ($19_3$) of a potentiometer (19), said device determining the time ($t_2$) of charging or discharging of the capacitor (16) as a function of the total resistance ($19_1$ and $19_2$) of the potentiometer and the time ($t'_2$) of charging or discharging of the capacitor (16) as a function of the resistance presented by the potentiometer (19) between an end terminal ($19_1$) and the wiper ($19_3$), characterized in that, the said apparatus being a microprocessor (10), the times $t_2$ and $t'_2$ are the times of charging and discharging of the capacitor (16) through, respectively, the total resistance of the potentiometer and the resistance constituted by this potentiometer between the said end terminal ($19_1$) and the wiper ($19_3$) and in that the position ($\alpha$) of the wiper is set by the equation:

$$a = \frac{t'_2}{t_2}$$

2. The device as claimed in claim 1, characterized in that the capacitor (16) and the potentiometer (19) have a terminal (18 and 41) connected with an input (11) of the microprocessor, the said times ($t_2$ and $t'_2$) being the times set by the potential at this input (11) in order to attain a predetermined value (VO).

3. The device as claimed in claim 1 or claim 2, characterized in that prior to the measurement the capacitor (16) is discharged.

4. The device as claimed in claim 2, characterized in the wiper ($19_3$) of the potentiometer is connected with a terminal (14) which is put at a predetermined potential, for instance that of ground, at the time of measurement of the charge or the discharge time through the resistance.

5. The device as claimed in claim 2 or claim 4, characterized in the end ($19_2$) of the potentiometer which is opposite to the input (11) of the microprocessor is connected with a terminal (15) which is set at a predetermined potential, for instance that of ground, at the time of measurement of the charge or the discharge time through the resistance.

6. The device as claimed in claim 4 or claim 5, characterized in that the terminal (14 and 15) set at a predetermined potential is an output of the microprocessor.

7. The device as claimed in any one of the preceding claims 2, 4, 5 or 6, characterized in that the predetermined value ($V_0$) constitutes an input threshold (11) of the microprocessor.

8. The application of the device as claimed in any one of the preceding claims 1 through 7 for indicating a desired value for the control of a washing machine, such as the temperature desired for the washing water, the speed desired of the rotation of the drum when spinning, or the load of washing introduced into the drum.

**Patentansprüche**

1. Kondensatoreinrichtung (16) für die Eingabe von durch die Position des Schiebekontakts ($19_3$) eines Potentiometers (19) dargestellten Analogdaten in ein Gerät, wobei diese Einrichtung die Zeit ($t_2$) des Auf- oder Entladens des Kondensators (16) in Abhängigkeit vom Gesamtwiderstand ($19_1$, $19_2$) des Potentiometers und die Zeit ($t'_2$) des Auf- oder Entladens des Kondensators (16) in Abhängigkeit von dem Widerstand, der durch das Potentiometer (19) zwischen einem Endanschluß ($19_1$) und dem Schiebekontakt ($19_3$) gegeben ist, bestimmt, dadurch gekennzeichnet, daß das Gerät ein Mikroprozessor (10) ist und die Zeiten $t_2$ und $t'_2$ die Aufladungs- oder Entladungszeiten des Kondensators (16) über den Gesamtwiderstand des Potentiometers bzw. über den Widerstand, der durch dieses Potentiometer zwischen dem Endanschluß ($19_1$) und dem Schiebekontakt ($19_3$) gegeben ist, sind, und daß die Position ($\alpha$) des Schiebekontakts durch die Formel

$$\alpha = t'_2/t_2$$

gegeben ist.

2. Einrichtung gemäß Anspruch 1, dadurch gekennzeichnet, daß der Kondensator (16) und das Potentiometer (19) einen mit einem Eingang (11) des Mikroprozessors verbundenen Anschluß ($18_1$, 41) aufweisen, wobei die Zeiten ($t_2$, $t'_2$) diejenigen sind, in denen das Potential an diesem Eingang (11) einen vorgegebenen Wert ($V_0$) erreicht.

3. Einrichtung gemäß Anspruch 1 oder 2, dadurch gekennzeichnet, daß der Kondensator (16) vor der Messung entladen wird.

4. Einrichtung gemäß Anspruch 2, dadurch gekennzeichnet, daß der Schiebekontakt ($19_3$) des Potentiometers mit einem Anschluß (14) verbunden ist, an dem ein bestimmtes Potential, beispielsweise Massepotential anliegt, wenn die Aufladungs- oder Entladungszeit über den Widerstand gemessen wird.

5. Einrichtung gemäß Anspruch 2 oder 4, dadurch gekennzeichnet, daß das Ende ($19_2$) des Potentiometers, das dem Eingang (11) des Mikroprozessors gegenüberliegt, mit einem Anschluß (15) verbunden ist, an dem ein bestimmtes Potential, beispielsweise Massepotential anliegt, wenn die Aufladungs- oder Entladungszeit über den Widerstand gemessen wird.

6. Einrichtung gemäß Anspruch 4 oder 5, dadurch gekennzeichnet, daß der Anschluß (14, 15), der auf einem bestimmten Potential gehalten wird, ein Ausgang des Mikroprozessors ist.

7. Einrichtung gemäß Anspruch 2, 4, 5 oder 6, dadurch gekennzeichnet, daß der vorgegebene Wert ($V_0$) einen Schwellenwert des Eingangs (11) des Mikroprozessors bildet.

8. Anwendung einer Einrichtung gemäß einem der Ansprüche 1 bis 7 auf die Anzeige eines Einstellwertes für die Steuerung einer Waschmaschine, etwa der gewünschten Temperatur des Waschwassers, der gewünschten Geschwindigkeit für die Drehung der Trommel beim Schleudern oder der in die Trommel eingegebenen Wäscheladung.

FIG_1

FIG_2